# EUROPEAN PATENT APPLICATION

(11) **EP 1 602 978 A1**
(43) Date of publication of application: **07.12.2005**
(21) Application number: 04710494.8
(22) Date of filing: 12.02.2004
(51) Int. Cl.: G03F 7/20, H01L 21/027, G02F 1/13, C04B 35/565, C04B 35/584

(54) **EXPOSURE APPARATUS FOR LIQUID CRYSTAL PANEL AND EXPOSURE APPARATUS**

(30) Priority: 21.02.2003 JP 2003044973
(71) Applicant: Nihon Ceratec Co., Ltd., Sendai-shi, Miyagi 981-3292 (JP); OHMI, Tadahiro, Sendai-shi, Miyagi 980-0813 (JP)
(72) Inventor: TAKEHISA, Kiwamu, Sendai-shi, Miyagi 9800866 (JP); MORIYAMA, Shirou, Nihon Ceratec Co, Ltd, Sendai-shi, Miyagi 981.3292 (JP); SAKAMAKI, Makoto, Nihon Ceratec Co, Ltd, Sendai-shi, Miyagi 981.3292 (JP); OHMI, Tadahiro, Sendai-shi, Miyagi 980-0813 (JP)
(74) Representative: Barendregt, Frank
(86) International application number: PCT/JP2004/001454
(87) International publication number: WO 2004/074939

(57) **Abstract**

A composite ceramic material with a honeycomb structure which is composed by adding glass into silicon carbide is used for a mask stage (2) and a substrate stage (12) in an exposure apparatus (100) for liquid crystal panels.

## Description

### Technical Field

This invention reiaies to a structure of an exposure apparatus and, in particular, relates to a structure of an exposure apparatus suitable for manufacturing liquid crystal panels.

### Background Art

In order to manufacture a liquid crystal panel, it is necessary to form on a substrate a circuit pattern adapted for controlling liquid crystals. For forming the circuit pattern on the substrate, use is made of a mask having the circuit pattern to transfer and expose the circuit pattern of the mask onto the substrate. An apparatus for this is called an exposure apparatus for a liquid crystal panel. Since mirrors are used for the transfer, an optical system of the exposure apparatus for the liquid crystal panel is sometimes called a mirror projection optical system.

On the other hand, the sizes required for liquid crystal panels have been increasing year by year. As a result, masks used for manufacturing liquid crystal panels have also been increasing in size. However, it is difficult to transfer and expose the whole circuit pattern of a large-size mask onto a substrate at a time. In view of this, the type becoming predominant is such that both the mask and the substrate are moved (scan) while transferring and exposing a part of the pattern of the mask, thereby transferring and exposing the whole pattern of the mask onto the substrate. The exposure apparatus of this type may also be called a scan-type exposure apparatus. With respect to the exposure apparatus for the liquid crystal panel, description is given, for example, in "O plus E" (Vol. 24, No. 11, November 2002, pp. 1209-1213).

On the other hand, with respect to of a stage used for scanning the mask or the substrate, for example, in an exposure apparatus used for exposure for a semiconductor device, thermal expansion of the stage due to a change in ambient temperature adversely affects a pattern exposed. In view of this, as a material of the stage, use has often been made of ceramic having a relatively small thermal expansion coefficient.

The stage of the exposure apparatus for the semiconductor device is disclosed, for example, in Japanese Unexamined Patent Application Publication (JP-A) No. H11-223690. Japanese Patent (JP-B) No. 3260340 describes that ceramic is used as a stage forming material.

As compared with the exposure apparatus for the semiconductor device, both the mask and the substrate are larger by one figure in the exposure apparatus for the liquid crystal panel. Then, in order to realize the large-size and strong stage, a large quantity of ceramic being a stage material is used. However, as a result of using the large quantity of ceramic, there are those instances where the weight of the stage reaches several tons, which results in about 20 tons as the weight of the whole exposure apparatus. Further, in order to prevent occurrence of vibration against a large reaction force that is generated upon reversal of movement of the large-weight stage, the installation place for the exposure apparatus should be strongly structured.

Moreover, when the place where the exposure apparatus for the liquid crystal panel is installed is strongly structured in a clean room where liquid crystal panels are manufactured, the following problem has arisen. Specifically, not only the construction cost of the clean room increases, but also the installation place of the exposure apparatus for the liquid crystal panel is fixed. In addition, there is no flexibility in the productivity and, further, it is necessary to determine the number of exposure apparatuses for liquid crystal panels to be introduced at the time of designing the clean room.

As described above, for the stage of the conventional exposure apparatus for the liquid crystal panel, the ceramic that has been used for the stage of the exposure apparatus for the semiconductor device has been utilized as it is. Accordingly, it is not possible to achieve a lighter weight than silicon carbide having the lowest density of about 3.1g/cm³ and, by using the large quantity of ceramic, the whole apparatus becomes extremely heavy to thereby cause various drawbacks.

Therefore, it is an object of this invention to provide an exposure apparatus that is reduced in weight and is particularly suitable for manufacturing liquid crystal panels.

### Disclosure of the Invention

For accomplishing the foregoing object, use is made in this invention of ceramic having a density of 3.0g/cm³ or less, particularly composite ceramic, as a material forming a stage. According to this, although the conventional pure ceramic alone cannot be made lighter than silicon carbide, it is possible to achieve the density of 3.0g/cm³ or less by mixing a material lighter than silicon carbide.

Further, by making a selection, as the mixing material, of a material having a property of contraction following a temperature rise as opposed to the pure ceramic, the thermal expansion can be canceled. This makes it possible to obtain a material having a thermal expansion coefficient of substantially 0 at a specific temperature.

For example, by adding a glass component to silicon carbide, it is possible to realize composite ceramic that is light, i.e. with a density of about 2.5g/cm³, and further has a thermal expansion coefficient that becomes 0 near a room temperature. This is lighter by about 40% than alumina ceramic having a density of about 4g/cm³, which has conventionally been used in general. Further, even when a large-size stage is formed by using a long member made of this composite ceramic, there is no occurrence of expansion or contraction.

With respect to composite ceramic, description is given, for example, in Japanese Patent (JP-B) No. 3260340 as referred to before.

Further, in this invention, by forming this composite ceramic into a honeycomb structure or a porous structure, the weight is further reduced to about 1/2 to 1/8. Particularly, in the case of employing the honeycomb structure to thereby make hollow the inside of the ceramic, the honeycomb structure in this invention may have holes each allowed to have not only a regular hexagonal shape, but also a slightly inclined hexagonal shape, or an octagonal shape. That is, each hole may have any shape in which adjacent surfaces are obliquely joined to each other as different from a rectangular or square shape. Since the stage linearly moves in X and Y directions in the plane, when use is made of ceramic having rectangular or square holes like conventional, there are those instances where the ceramic itself is slightly deformed due to a large reaction force upon reversal of the movement of the stage. On the other hand, in this invention, since there are provided the holes each having the oblique shape, there is no occurrence of the deformation of the stage upon the reversal thereof.

Further, according to this invention, there is provided an exposure apparatus which transfers and exposes a pattern of a mask onto a substrate while moving at least one of the mask and the substrate by the use of a stage. In this exposure apparatus, use is made of ceramic having a density of 3.0g/cm³ or less as a material forming the stage and the stage is formed by bonding together a plurality of ceramic members.

### Brief Description of the Drawings

Fig. 1 is a diagram showing a schematic structure of an exposure apparatus for a liquid crystal panel according to an embodiment of this invention; and
Fig. 2 is a diagram for explaining a structure of a stage base 3b shown in Fig. 1.

### Best Mode for Carrying Out the Invention

Hereinbelow, an embodiment of this invention will be described with reference to the drawings.

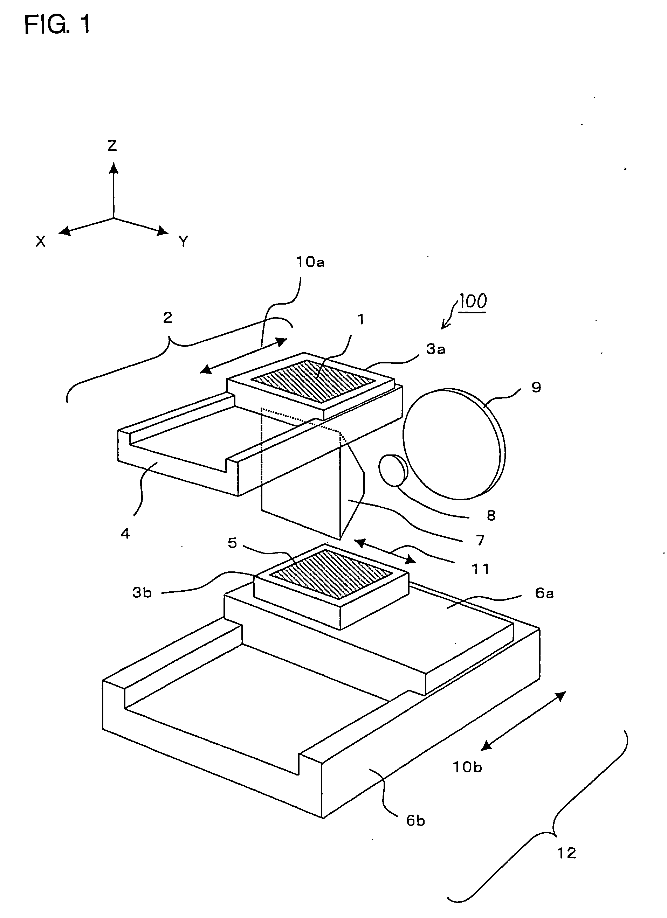

Fig. 1 is a structural diagram of an exposure apparatus 100 for a liquid crystal panel as the embodiment of this invention. A mask 1 with a circuit pattern drawn thereon is fixed on a stage base 3a in a mask stage 2. The stage base 3a is placed on a stage guide 4 and configured to be reciprocatingly movable in an X direction indicated in Fig. 1. That is, the stage base 3a is configured to be scannable in scan directions 10a.

On the other hand, in a substrate stage 12, a substrate 5 is fixed on a stage base 3b. The stage base 3b is configured to be reciprocatingly movable (movable stepwise) on a stage guide 6a in a Y direction indicated in Fig. 1. That is, the stage base 3b is movable stepwise on the stage guide 6a in step directions 11. Further, the stage guide 6a mounted thereon with the stage base 3b is configured to be reciprocatingly movable on a stage guide 6B in the X direction, i.e. scannable in scan directions 10b equal to the foregoing scan directions 10a.

Drive mechanisms such as ball-screw mechanisms or linear motors are used for driving the stage bases 3a and 3b and the stage guide 6a. Further, respective moving portions thereof are arranged to be movable in the state where they are supported by bearings such as hydrostatic bearings. However, since these drive mechanisms and bearings are not the major points of this invention, detailed explanation thereof is omitted.

An image of part of the circuit pattern of the mask 1 is reflected by a trapezoidal mirror 7, a convex mirror 8, and a concave mirror 9 and again hits the trapezoidal mirror 7 so as to be transferred onto the substrate 5. The mask 1 and the substrate 5 are both scanned in the X direction and, after having been scanned once, the stage base 3b makes a step in the Y direction. By repeating this, the whole circuit pattern of the mask 1 is transferred and exposed onto the substrate 5.

For the mask stage 2 and the substrate stage 12 in this embodiment, use is made of a composite ceramic material formed by adding a glass component to silicon carbide. This has a density of about 2.5g/cm³. Therefore, this composite ceramic is reduced in density by about 40% as compared with the general alumina ceramic so that the mask stage 2 and the substrate stage 12 can be reduced in weight.

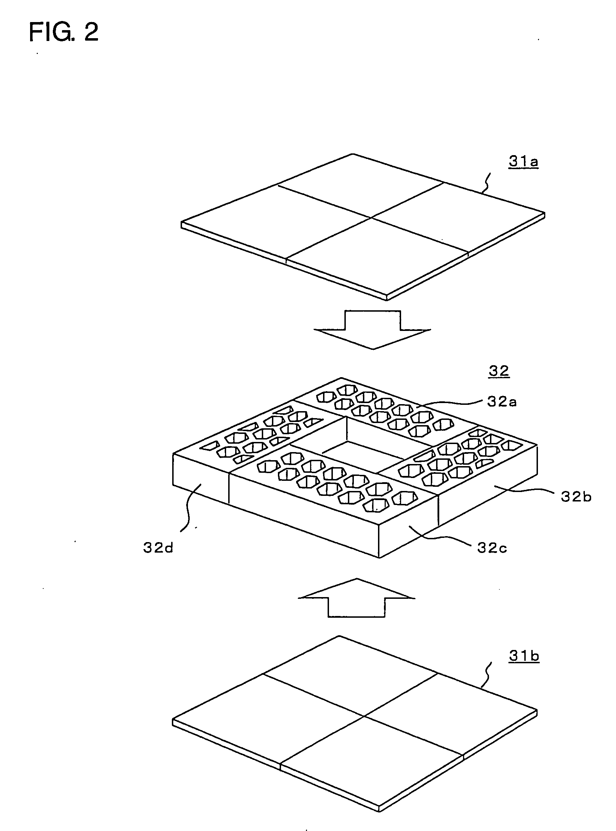

Next, in order to explain a structure of a stage member in the exposure apparatus for the liquid crystal panel of this invention, a structure of the stage base 3b of the exposure apparatus 100 for the liquid crystal panel will be described as one example with reference to Fig. 2.

The stage base 3b is in the form of a ceramic panel 31a, a ceramic block joined body 32, and a ceramic panel 31b, i.e. three members, which are integrated together. As shown in Fig. 2, in this example, the ceramic panel 31a and the ceramic panel 31b are each formed by bonding together four ceramic panels so as to be flush with each other, thereby providing a larger area. The ceramic block joined body 32 is, in this example, obtained by bonding together four ceramic blocks 32a, 32b, 32c, and 32d with an adhesive so as to form a square frame shape having an opening at a center portion thereof. The ceramic panels 31a and 31b and the ceramic blocks 32a to 32d are all made of composite ceramic containing silicon carbide and glass as main components and having a thermal expansion coefficient of 0 at a specific temperature, for example, around 23°C near the room temperature. Since this composite ceramic has a density of about 2.5g/cm³, the weight is reduced by 40% as compared with the conventional alumina ceramic having a density of about 4g/cm³.

As the joining method for the ceramics, use can be made of a method of applying a low melting point metal, an inorganic adhesive, a glass sealing agent, or the like to joining surfaces and heating them, solid state bonding such as a method of bonding together the ceramics and keeping them at a high temperature while applying a pressure thereto, laser welding, or the like.

Further, as shown in Fig. 2, the ceramic blocks 32a to 32d each have a so-called honeycomb structure with many holes. The shape of each hole is set to a polygonal shape such as a hexagonal shape or an octagonal shape. Further, when joining these four ceramic blocks, the center portion is vacant. As a result, as compared with the case where the ceramic block joined body 32 is formed as a solid body having no opening at its center portion, the usage amount of the ceramic material is reduced by 80% while the mechanical strengths are substantially equal to each other.

In this invention, use is made of the ceramic reduced in weight particularly by the honeycomb structure. The reason is as follows. With respect to a conventional exposure apparatus stage, there was a case where use was made of a ceramic that was reduced in weight by hollowing out the inside in a square shape. However, in this case, since the stage moves in the X and Y directions, there were those instances where the ceramic was slightly deformed due to a large reaction force applied upon reversal of the movement.

On the other hand, in this invention, by employing the honeycomb structure with many holes each having the hexagonal or octagonal shape, it becomes strong enough against the force applied in the X or Y direction so as not to be deformed.

As described above, since the stage base 3b is reduced in weight by about 40% with the material itself and by 80% structurally, it is reduced in weight by 88% [= 0.4+ (0.6×0.8)] in total.

Further, since the thermal expansion coefficient is 0 near the room temperature, it is possible to reduce an exposure positioning error caused by expansion and contraction due to a change in ambient temperature so that the exposure can be performed with high accuracy.

The stage base 3a, the stage guide 4, and the stage guides 6a and 6b in the exposure apparatus 100 for the liquid crystal panel are, likewise, made of the composite ceramic formed by adding glass to silicon carbide and each also have the honeycomb structure. Therefore, the weight of the whole exposure apparatus 100 for the liquid crystal panel is reduced in weight by about 60%.

When composite ceramic formed by adding glass to silicon nitride is used in place of the composite ceramic formed by adding glass to silicon carbide, the same effect can be obtained.

Further, the ceramic blocks of the ceramic block joined body 32 constituting the stage base 3b may each have a porous structure in place of the honeycomb structure. Also in this case, a weight reduction can be similarly achieved. Since porous ceramic bodies are widely used industrially for filters, heat insulators, catalyst carriers, and so on, these techniques can be utilized.

For example, as a method of manufacturing the porous ceramic body, there is known a method of mixing what will be lost by burning into a compact and then burning them out to provide holes remaining inside. As the mixing matter, use is made of what will be lost by burning, like inorganic matter such as carbon or organic matter such as urethane. On the other hand, in the case of a hollow silica filler or the like, even if it remains after burning, the amount thereof is extremely small as compared with the volume of a hole and, in addition, since the composition thereof is the same as that of the main component in the foregoing composite ceramic, it does not exert an influence upon various properties of the composite ceramic. As the shape of the mixing matter, use may be made of the shape of powder, a bead, a fiber, a hollow pipe, or the like depending on the shape of a hole.

Similarly, it is also possible to mix a substance, easily dissolvable in a chemical liquid, into a compact, sinter the compact by burning and then subject it to erosion by the chemical liquid, thereby providing holes remaining inside.

Further, use can also be made of one formed into a honeycomb shape by extrusion molding.

This invention may be carried out in the following modes.

### [First Mode]

An exposure apparatus that transfers and exposes a pattern of a mask onto a substrate while moving at least one of the mask and the substrate by the use of a stage, wherein use is made, as a material forming the stage, of ceramic having a density of 3.0g/cm³ or less and a thermal expansion coefficient of -1.5 to 1.5×10⁻⁶/°C at a room temperature.

### [Second Mode]

An exposure apparatus according to the foregoing first mode, wherein the ceramic is dense composite ceramic containing silicon carbide and glass as main components.

### [Third Mode]

An exposure apparatus according to the foregoing first mode, wherein the ceramic is dense composite ceramic containing silicon nitride and glass as main components.

### [Fourth Mode]

An exposure apparatus according to any of the foregoing first to third modes, wherein the ceramic has a honeycomb structure so as to be reduced in weight to 2/3 or less as compared with dense ceramic.

### [Fifth Mode]

An exposure apparatus according to any of the foregoing first to third modes, wherein the ceramic has a porous structure so as to be reduced in weight to 2/3 or less as compared with dense ceramic.

### [Sixth Mode]

An exposure apparatus according to any of the foregoing first to fifth modes, wherein the ceramic is reduced in weight to 1/2 or less as compared with dense ceramic by forming the ceramic having the porous structure into the honeycomb structure.

As described above, according to this invention, it is possible to provide the exposure apparatus that is largely reduced in weight and that enables highly accurate exposure. Particularly, with respect to the case of being applied to the exposure apparatus for manufacturing liquid crystal panels, not only the weight is largely reduced but also the reaction force generated upon reversal of the movement of the stage is largely reduced due to the reduction in weight as compared with the conventional exposure apparatus for the liquid crystal panel and, therefore, it is not necessary to strengthen the structure of the place where the exposure apparatus for the liquid crystal panel is installed in the clean room. Accordingly, it becomes easy to move the installation place of the exposure apparatus for the liquid crystal panel within the clean room and to increase the number of the apparatuses and, therefore, the flexibility can be obtained in the productivity.

### Industrial Applicability

This invention is applicable not only to the exposure apparatus for the liquid crystal panel but also to an exposure apparatus for a semiconductor device. Further, this invention is applicable not only to the exposure apparatus that simultaneously moves the mask and the substrate as shown in Fig. 1, but also to an exposure apparatus that moves only one of them. Further, the stage in this invention may be one that is formed by applying the foregoing honeycomb structure or porous structure to the existing pure silicon carbide ceramic or pure silicon nitride ceramic or, depending on circumstances, the existing pure alumina ceramic.

## Claims

1. An exposure apparatus for a liquid crystal panel, which transfers and exposes a pattern of a mask onto a substrate while moving at least one of said mask and said substrate by the use of a stage, said exposure apparatus **characterized in that** use is made of ceramic having a density of 3.0g/cm³ or less as a material forming said stage.

2. An exposure apparatus for a liquid crystal panel according to claim 1, **characterized in that**, as said ceramic having the density of 3.0g/cm³ or less, use is made of the ceramic having a thermal expansion coefficient of -1.5 to 1.5×10⁻⁶/°C at a room temperature and containing silicon carbide and glass as main components.

3. An exposure apparatus for a liquid crystal panel according to claim 1, **characterized in that**, as said ceramic having the density of 3.0g/cm³ or less, use is made of the ceramic having a thermal expansion coefficient of -1.5 to 1.5×10⁻⁶/°C at a room temperature and containing silicon nitride and glass as main components.

4. An exposure apparatus for a liquid crystal panel according to any of claims 1 to 3, **characterized in that** said ceramic having the density of 3.0g/cm³ or less has a honeycomb structure.

5. An exposure apparatus for a liquid crystal panel according to any of claims 1 to 3, **characterized in that** said ceramic having the density of 3.0g/cm³ or less has a porous structure.

6. An exposure apparatus for a liquid crystal panel according to claim 1, **characterized in that** said ceramic is reduced in weight to 1/2 or less as compared with dense ceramic by forming the ceramic having a porous structure into a honeycomb structure.

7. An exposure apparatus for a liquid crystal panel according to claim 2, **characterized in that** said ceramic is reduced in weight to 1/2 or less as compared with dense ceramic by forming the ceramic having a porous structure into a honeycomb structure.

8. An exposure apparatus for a liquid crystal panel according to claim 3, **characterized in that** said ceramic is reduced in weight to 1/2 or less as compared with dense ceramic by forming the ceramic having a porous structure into a honeycomb structure.

9. An exposure apparatus for a liquid crystal panel according to claim 4, **characterized in that** said ceramic is reduced in weight to 1/2 or less as compared with dense ceramic by forming the ceramic having a porous structure into the honeycomb structure.

10. An exposure apparatus for a liquid crystal panel according to claim 5, **characterized in that** said ceramic is reduced in weight to 1/2 or less as compared with dense ceramic by forming the ceramic having the porous structure into a honeycomb structure.

11. An exposure apparatus which transfers and exposes a pattern of a mask onto a substrate while moving at least one of said mask and said substrate by the use of a stage, said exposure apparatus **characterized in that** use is made of ceramic as a material forming said stage and said ceramic is in the form of a silicon carbide sintered body or a silicon nitride sintered body having a thermal expansion coefficient of 0.5 to 3.0×10⁻⁶/°C at a room temperature and is reduced in weight by a honeycomb structure, a porous structure, or a combination thereof.

12. An exposure apparatus which transfers and exposes a pattern of a mask onto a substrate while moving at least one of said mask and said substrate by the use of a stage, said exposure apparatus **characterized in that** use is made of ceramic having a density of 3.0g/cm³ or less as a material forming said stage and said stage is formed by bonding together a plurality of ceramic members.
